# EUROPÄISCHE PATENTSCHRIFT

(11) **EP 3 458 865 B1**
(45) Veröffentlichungstag und Bekanntmachung des Hinweises auf die Patenterteilung: **01.06.2022**
(21) Anmeldenummer: 17712091.2
(22) Anmeldetag: 17.03.2017
(51) Int. Cl.: G01R 31/36

(54) **VORRICHTUNG UND VERFAHREN ZUR BESTIMMUNG EINER KAPAZITÄT EINES ELEKTRISCHEN ENERGIESPEICHERS**
DEVICE AND METHOD FOR DETERMINING A CAPACITANCE OF AN ELECTRICAL ENERGY STORAGE DEVICE
DISPOSITIF ET PROCÉDÉ POUR DÉTERMINER UNE CAPACITÉ D'UN ACCUMULATEUR D'ÉNERGIE ÉLECTRIQUE

(30) Priorität: 17.05.2016 DE 102016208422
(43) Veröffentlichungstag der Anmeldung: 27.03.2019
(73) Patentinhaber: Robert Bosch GmbH, 70442 Stuttgart (DE)
(72) Erfinder: LEHMANN, Siegfried, 73061 Ebersbach (DE); SCHLASZA, Christian, 73728 Esslingen (DE)
(86) Internationale Anmeldenummer: PCT/EP2017/056432
(87) Internationale Veröffentlichungsnummer: WO 2017/198359

(56) Entgegenhaltungen:
- JP-A- 2009 244 088
- US-A- 4 743 855
- US-A1- 2003 204 328
- US-A1- 2012 019 253
- US-A1- 2012 123 712
- US-A1- 2015 226 812

## Beschreibung

Die vorliegende Erfindung betrifft die Bestimmung der Kapazität eines elektrischen Energiespeichers. Insbesondere betrifft die vorliegende Erfindung eine Vorrichtung und ein Verfahren zur Bestimmung der Kapazität eines elektrischen Energiespeichers, wie zum Beispiel eines Akkumulators.

### Stand der Technik

Die Druckschrift EP 2 447 728 A1 offenbart ein Messsystem für eine Batteriezelle. Die Batteriezelle kann dabei mittels einer Impedanz belastet werden, wobei die Belastung über einen getaktet angesteuerten Schalter zu bzw. abgeschaltet werden kann. Ein Spannungsabfall über der Impedanz wird tiefpassgefiltert und anschließend ausgewertet.

Elektrische Energiespeicher, wie zum Beispiel Lithium-Ionen-Batterien finden in zahlreichen Gebieten Anwendung. Beispielsweise werden sie als Traktionsbatterien in Elektrofahrzeugen eingesetzt. Die Kapazität der einzelnen Zellen in solchen Energiespeichern kann über die Lebensdauer variieren. Für die Evaluierung der Zellen in einem solchen Energiespeicher ist die Überprüfung der Kapazität von großem Interesse.

Aktuell müssen die Zellen eines Energiespeichers, wie beispielsweise Lithium-Ionen-Batteriezellen, vollständig auf- und entladen werden, um eine genaue und zuverlässige Aussage über deren Kapazität zu erhalten. Alternativ können gegebenenfalls auch Daten eines vorhandenen Batteriemanagementsystems Aufschluss über den Zustand und die Kapazität der einzelnen Batteriezellen geben. Hierzu muss jedoch das Batteriemanagementsystem genau auf die einzelnen Zellen eines solchen Energiespeichers abgestimmt sein.

Weiterer relevanter Stand der Technik wird in JP 2009 244088 A, US 2012/123712 A1, US 2012/019253 A1 sowie US 2003/204328 A1 veröffentlicht.

### Offenbarung der Erfindung

Die vorliegende Erfindung offenbart eine Vorrichtung zur Bestimmung einer Kapazität eines elektrischen Energiespeichers mit den Merkmalen des Patentanspruchs 1 und ein Verfahren zur Bestimmung der Kapazität eines elektrischen Energiespeichers mit den Merkmalen des Patentanspruchs 7.

### Vorteile der Erfindung

Der vorliegenden Erfindung liegt die Erkenntnis zugrunde, dass der Bestimmung der Kapazität eines elektrischen Energiespeichers, wie zum Beispiel von wiederaufladbaren Batterien, eine große Bedeutung zukommt. Insbesondere liegt der vorliegenden Erfindung dabei die Erkenntnis zugrunde, dass bereits die alleinige Analyse einer Phasenverschiebung zwischen Strom und Spannung bei einer Impedanzmessung eines elektrischen Energiespeichers zuverlässige Rückschlüsse auf die Kapazität des elektrischen Energiespeichers erlaubt. Daher ist es eine Idee der vorliegenden Erfindung, dieser Erkenntnis Rechnung zu tragen und eine Vorrichtung sowie ein Verfahren vorzusehen, wodurch eine Kapazitätsbestimmung des elektrischen Energiespeichers basierend auf einer Phasenverschiebung bei einer Impedanzmessung des elektrischen Energiespeichers ermöglicht werden kann. Eine Impedanzmessung des elektrischen Energiespeichers zur Bestimmung einer Phasenverschiebung zwischen Strom und Spannung kann dabei durch eine sehr geringe und zeitlich sehr kurze Belastung des elektrischen Energiespeichers realisiert werden. Dies ermöglicht eine besonders rasche und schonende Bestimmung der Kapazität des elektrischen Energiespeichers.

Für die Impedanzmessung des elektrischen Energiespeichers muss dabei der elektrische Energiespeicher mit einer definierten Last belastet werden. Insbesondere kann hierzu an dem elektrischen Energiespeicher beispielsweise eine Belastung mit einer vorgegebenen Stromamplitude erfolgen. Für eine Impedanzmessung ist dabei insbesondere eine periodische Belastung mit einer vorgegebenen Frequenz erforderlich. Hierbei sind zur erfindungsgemäßen Impedanzmessung insbesondere Frequenzen von mehr als ein Hertz, insbesondere zwischen einem Hertz und zehn bzw. fünfzehn Hertz ausreichend. Auf diese Weise kann eine relativ schnelle Kapazitätsbestimmung innerhalb weniger Sekunden realisiert werden. Alternativ zu einer Belastung des elektrischen Energiespeichers mit einem vordefinierten Stromverlauf ist auch eine Messung des elektrischen Stroms bei vorgegebenem Spannungsverlauf möglich.

Bei der periodischen Belastung des elektrischen Energiespeichers zur Impedanzmessung ist beispielsweise ein Sinussignal möglich. Aufgrund der elektrochemischen Eigenschaften der Batterie wird sich bereits nach wenigen Perioden eine quasi-stationäre Systemantwort einstellen. Anschließend ist eine Impedanzmessung und insbesondere eine Bestimmung der Phasenverschiebung zwischen eingestellter Belastung und sich einstellender quasi-stationärer Systemantwort, also beispielsweise zwischen Strom und Spannung möglich.

Aus der so ermittelten Phase der Impedanz des elektrischen Energiespeichers kann daraufhin auf die Kapazität des elektrischen Energiespeichers geschlossen werden. Beispielsweise kann die Phase der Impedanz des elektrischen Energiespeichers mit einer zuvor ermittelten Funktion oder zuvor ermittelten Kennlinie verglichen werden, um die aktuelle Kapazität des elektrischen Energiespeichers zu bestimmen. Die Ermittlung der Kennlinien bzw. Funktionen für den Zusammenhang zwischen Phase der Impedanz und Kapazität des elektrischen Energiespeichers kann dabei beispielsweise zuvor mittels praktischer Messungen oder theoretischer Simulation erfolgen.

Gemäß einer Ausführungsform umfasst die Auswertevorrichtung einen Speicher, der dazu ausgelegt ist, einen zuvor ermittelten Zusammenhang zwischen Phasenverschiebung und Kapazität des elektrischen Energiespeichers zu speichern. Die Auswertevorrichtung kann dabei dazu ausgelegt sein, basierend auf den in dem Speicher abgelegten Zusammenhängen zwischen Phasenverschiebung und Kapazität die Kapazität des elektrischen Energiespeichers zu bestimmen. Der Zusammenhang zwischen Phasenverschiebung und Kapazität kann dabei als eine Funktion zwischen Phasenverschiebung und Kapazität definiert werden. Alternativ kann auch eine Tabelle, beispielsweise eine Lookup-Tabelle in dem Speicher der Auswertevorrichtung abgespeichert sein, die für unterschiedliche Phasenverschiebungen jeweils eine korrespondierende Kapazität des elektrischen Energiespeichers definiert. Insbesondere ist dabei auch eine Interpolation zwischen verschiedenen in dem Speicher der Auswertevorrichtung abgespeicherten Werten möglich. Gegebenenfalls kann in dem Speicher der Auswertevorrichtung auch ein Zusammenhang zwischen Kapazität und Phasenverschiebung sowie einem oder mehreren weiteren Parametern des elektrischen Energiespeichers abgespeichert sein. Hierzu können beispielsweise für die weiteren Parameter des elektrischen Energiespeichers unterschiedliche Funktionen bzw. mehrere Tabellen abgespeichert sein. Alternativ ist auch eine mehrdimensionale Funktion bzw. ein mehrdimensionales Kennlinienfeld möglich, das in dem Speicher der Auswertevorrichtung abgespeichert ist.

Gemäß einer weiteren Ausführungsform ist die Belastungsvorrichtung dazu ausgelegt, den elektrischen Energiespeicher mit einem periodischen Belastungssignal zu belasten, wobei die Frequenz des periodischen Belastungssignals zwischen einem und fünfzehn Hertz, insbesondere zwischen einem und zehn Hertz liegt. Belastungssignale im ein- und zweistelligen Hertzbereich, also zwischen einem Hertz und etwa 100 Hertz sind möglich. Periodische Belastungssignale mit einer Frequenz in diesem Bereich, insbesondere einer Frequenz von nur wenigen Hertz sind für eine Impedanzmessung des elektrischen Energiespeichers zur Bestimmung der Kapazität besonders gut geeignet.

Gemäß einer Ausführungsform ist die Frequenz des periodischen Belastungssignals anpassbar. Auf diese Weise kann die Bestimmung der Kapazität des elektrischen Energiespeichers flexibel auf unterschiedliche System- bzw. Rahmenbedingungen angepasst werden.

Gemäß einer weiteren Ausführungsform ist die Auswertevorrichtung dazu ausgelegt, die Kapazität des elektrischen Energiespeichers unter Verwendung weiterer Parameter des elektrischen Energiespeichers zu bestimmen. Insbesondere kann die Auswertevorrichtung die Kapazität des elektrischen Energiespeichers unter Verwendung einer Temperatur des elektrischen Energiespeichers, einem aktuellen Ladezustand des elektrischen Energiespeichers, einer Kennung bzw. Typbezeichnung des elektrischen Energiespeichers und/oder mindestens einem weiteren Parameter des elektrischen Energiespeichers bestimmen. Auf diese Weise kann die Kapazitätsbestimmung des elektrischen Energiespeichers an zusätzliche weitere Rahmenbedingungen angepasst werden.

Gemäß der Erfindung umfasst die Vorrichtung zur Bestimmung der Kapazität des elektrischen Energiespeichers eine Detektorvorrichtung. Diese Detektorvorrichtung ist dazu ausgelegt, eine Temperatur des elektrischen Energiespeichers zu bestimmen. Auf diese Weise kann für die Bestimmung der Kapazität des elektrischen Energiespeichers die aktuelle Temperatur des elektrischen Energiespeichers mit einbezogen werden. Alternativ kann die Temperatur des elektrischen Energiespeichers und gegebenenfalls auch weitere Parameter des elektrischen Energiespeichers auch von einer weiteren Vorrichtung, wie zum Beispiel einem Batteriemanagementsystem oder ähnlichem bereitgestellt werden.

Gemäß der Erfindung ist die Detektorvorrichtung dazu ausgelegt, die Temperatur des elektrischen Energiespeichers basierend auf einer Belastung des elektrischen Energiespeichers mit einem weiteren periodischen Belastungssignal und einer Auswertung der Systemantwort des elektrischen Energiespeichers auf die Beaufschlagung des elektrischen Energiespeichers mit dem weiteren Belastungssignal zu bestimmen. Die Frequenz des weiteren periodischen Belastungssignals ist dabei größer als die Frequenz des periodischen Belastungssignals mit dem der elektrische Energiespeicher zur Bestimmung der Kapazität beaufschlagt wird. Auf diese Weise kann auch die Temperatur des elektrischen Energiespeichers basierend auf einer Impedanzmessung des elektrischen Energiespeichers erfolgen. Somit können gegebenenfalls für die Bestimmung der Temperatur und die Bestimmung der Kapazität des elektrischen Energiespeichers gemeinsame Komponenten verwendet werden. Durch die Verwendung von unterschiedlichen Frequenzen für die Temperaturbestimmung und die Kapazitätsbestimmung kann dabei eine Entkopplung der beiden Messungen erfolgen.

Gemäß einer weiteren Ausführungsform belastet die Belastungsvorrichtung den elektrischen Energiespeicher mit einem vorbestimmten Stromsignal. Die Messvorrichtung ist dabei dazu ausgelegt, als Systemantwort einen resultierenden Spannungsverlauf zu messen. Alternativ ist auch eine Belastung des elektrischen Energiespeichers mit einem vorbestimmten Spannungsverlauf und eine Auswertung des sich dabei einstellenden Stromverlaufs möglich. In beiden Fällen erfolgt jedoch die Belastung des elektrischen Energiespeichers mindestens solange, bis sich eine quasi-stationäre Systemantwort auf die Belastung des elektrischen Energiespeichers einstellt. Für die nachfolgende Kapazitätsbestimmung des elektrischen Energiespeichers wird dabei die Phasenverschiebung zwischen Strom und Spannung in dem quasi-stationären Zustand ausgewertet.

Gemäß einer Ausführungsform des Verfahrens zur Bestimmung der Kapazität des elektrischen Energiespeichers bestimmt der Schritt zum Bestimmen der Kapazität die Kapazität des elektrischen Energiespeichers unter Verwendung einer Kennlinie von zuvor ermittelten Zusammenhängen zwischen Phasenverschiebung und Kapazität. Werden für die Kapazitätsbestimmungen des elektrischen Energiespeichers noch weitere Parameter, wie beispielsweise Temperatur des elektrischen Energiespeichers, Ladezustand des elektrischen Energiespeichers oder gegebenenfalls weitere Parameter berücksichtigt, so kann der Schritt zum Bestimmen der Kapazität des elektrischen Energiespeichers des Kapazität entweder basierend auf einem mehrdimensionalen Kennlinienfeld ermitteln oder alternativ aus einer Mehrzahl von vorgegebenen Kennlinien jeweils diejenige Kennlinie auswählen, die am Besten zu den weiteren Parametern des elektrischen Energiespeichers korrespondiert.

Gemäß einer Ausführungsform umfasst das Verfahren ferner einen Schritt zum Klassifizieren des elektrischen Energiespeichers basierend auf der zuvor bestimmten Kapazität. Die Klassifizierung des Energiespeichers kann dabei beispielsweise eine Unterteilung in zwei Zustände wie "gut" und "schlecht" oder eine Klassifizierung in "funktionsfähig" und "fehlerhaft" umfassen. Hierbei kann die Klassifizierung durch Vergleich der ermittelten Kapazität des elektrischen Energiespeichers mit einem vorgegebenen Grenzwert erfolgen. Darüber hinaus ist auch eine detaillierte Klassifizierung in mehr als zwei Zustände möglich. Hierzu kann die ermittelte Kapazität des elektrischen Energiespeichers mit mehreren verschiedenen, abgestuften Grenzwerten erfolgen. Die Abstufung für die Einteilung in mehrere Klassen kann dabei beliebig fein erfolgen, Beispielsweise sind drei, vier, fünf, acht, zehn oder eine beliebige andere Anzahl von Klassen für die Klassifikation des elektrischen Energiespeichers möglich.

Die obigen Ausgestaltungen und Weiterbildungen lassen sich, soweit sinnvoll, beliebig miteinander kombinieren. Weitere Ausgestaltungen, Weiterbildungen und Implementierungen der Erfindung umfassen auch nicht explizit genannte Kombinationen von zuvor oder im Folgenden bezüglich den Ausführungsbeispielen beschriebenen Merkmalen der Erfindung. Insbesondere wird der Fachmann dabei auch Einzelaspekte als Verbesserungen oder Ergänzungen zu den jeweiligen Grundformen der Erfindung hinzufügen.

### Kurze Beschreibung der Zeichnungen

Die vorliegende Erfindung wird nachfolgend anhand der in den schematischen Figuren der Zeichnungen angegebenen Ausführungsbeispiele näher erläutert. Dabei zeigen:
- Figur 1:: eine schematische Darstellung einer Vorrichtung zur Bestimmung der Kapazität eines elektrischen Energiespeichers gemäß einer Ausführungsform;
- Figur 2:: eine schematische Darstellung eines Signalverlaufs zwischen Belastung und sich einstellender Systemantwort zur Impedanzmessung gemäß einer Ausführungsform;
- Figur 3:: eine schematische Darstellung eines Ablaufdiagramms für ein Verfahren zur Bestimmung der Kapazität eines elektrischen Energiespeichers, wie es einer Ausführungsform zugrunde liegt.

### Ausführungsformen der Erfindung

In allen Figuren sind gleiche bzw. funktionsgleiche Elemente und Vorrichtungen - soweit nicht anders angegeben - mit gleichen Bezugszeichen versehen. Elektrische Energiespeicher im Sinne der vorliegenden Erfindung sind alle Arten von Energiespeichern, die dazu ausgelegt sind, elektrische Energie über einen Zeitraum hinweg zu speichern und bei Bedarf die gespeicherte Energie in elektrischer Form wieder bereitzustellen. Insbesondere umfassen elektrischen Energiespeicher dabei wiederaufladbare Batterien, wie Akkumulatoren, zum Beispiel Lithium-Ionen-Batterien, Nickel-Metallhydrid-Akkumulatoren (NiMH), oder beliebige weitere Akkumulatoren. Die vorliegende Erfindung kann dabei sowohl auf einzelne Zellen von solchen Energiespeichern, als auch auf Module oder Batteriepacks mit einer Mehrzahl von solchen Zellen angewendet werden.

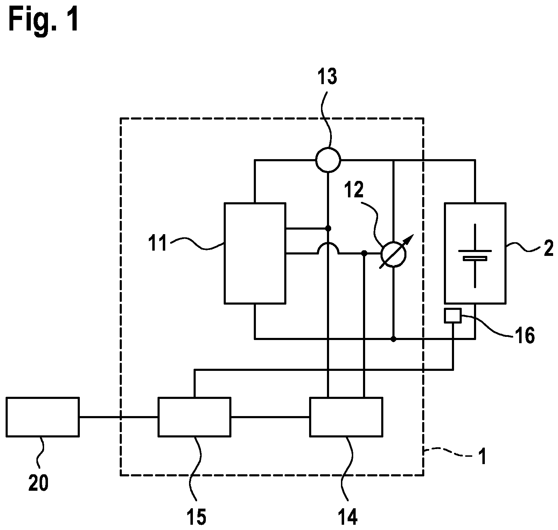

Figur 1 zeigt eine schematische Darstellung einer Vorrichtung 1 zur Bestimmung einer Kapazität eines elektrischen Energiespeichers 2 gemäß einer Ausführungsform. Die Vorrichtung 1 zur Bestimmung der Kapazität des elektrischen Energiespeichers 2 umfasst dabei eine Belastungsvorrichtung 11, eine Messvorrichtung, insbesondere eine Spannungsmessvorrichtung 12 und/oder eine Strommessvorrichtung 13, eine Rechenvorrichtung 14 sowie eine Auswertevorrichtung 15. Ferner kann die Vorrichtung 1 zur Bestimmung der Kapazität des elektrischen Energiespeichers 2 auch noch einen oder mehrere Sensoren, wie beispielsweise eine Detektorvorrichtung 16 zur Messung der Temperatur des elektrischen Energiespeichers 2 umfassen. Weiterhin kann die Vorrichtung 1 zur Bestimmung der Kapazität auch noch mit weiteren Komponenten, wie beispielsweise einem Batteriemanagementsystem 20 gekoppelt sein.

Zur Ermittlung der Kapazität des elektrischen Energiespeichers 2 wird der elektrische Energiespeicher 2 zunächst mit einem Erregungssignal belastet. Diese Belastung des elektrischen Energiespeichers 2 erfolgt dabei durch die mit dem elektrischen Energiespeicher 2 elektrisch verbundene Belastungsvorrichtung 11. Die Belastung des elektrischen Energiespeichers 2 kann dabei beispielsweise über einen durch den elektrischen Energiespeicher 2 fließenden vorgegebenen elektrischen Strom erfolgen. Alternativ kann die Belastung des elektrischen Energiespeichers 2 auch durch eine vorgegebene elektrische Spannung erfolgen. Bei der Belastung des elektrischen Energiespeichers 2 durch die Belastungsvorrichtung 11 handelt es sich dabei um ein periodisches Belastungssignal mit einer vorgegebenen Frequenz. Die Frequenz des periodischen Belastungssignals kann dabei im Bereich von wenigen Hertz liegen. Die Frequenz des periodischen Belastungssignals kann beispielsweise im ein- oder zweistelligen Hertzbereich, also zwischen einem und 100 Hertz liegen. Insbesondere kann die Frequenz des periodischen Belastungssignals im Bereich zwischen einem und fünfzehn oder zwischen einem und zehn Hertz liegen. So sind beispielsweise Belastungssignale mit einer Frequenz von einem, zwei, fünf Hertz oder ähnlichem möglich. Die Frequenz des periodischen Belastungssignals kann dabei durch die Belastungsvorrichtung 11 fest vorgegeben sein. Alternativ ist es auch denkbar, dass die Frequenz des periodischen Belastungssignals angepasst werden kann. Beispielsweise kann die Frequenz des periodischen Belastungssignals in dem zuvor beschriebenen Frequenzbereich in Abhängigkeit von weiteren Systemparametern, wie beispielsweise Temperatur, Ladezustand, Typ des elektrischen Energiespeichers 2 oder beliebigen weiteren Parametern angepasst werden.

Nachdem der elektrische Energiespeicher 2 durch die Belastungsvorrichtung 11 mit einem periodischen Belastungssignal belastet worden ist, wird sich hierauf eine entsprechende Systemantwort einstellen. So wird sich beispielsweise bei der Belastung des elektrischen Energiespeichers 2 mit einem vorgegebenen Strom, das heißt einer vorgegebenen Amplitude des Stroms, mit dem der elektrische Energiespeicher 2 belastet wird, entsprechend ein periodischer Spannungsverlauf einstellen. Alternativ wird sich bei der Belastung des elektrischen Energiespeichers 2 mit einem vorgegebenen Spannungsverlauf hierauf ein resultierender Stromverlauf einstellen. Dabei wird sich in der Regel nach wenigen Perioden des periodischen Belastungssignals ein quasi-stationärer Zustand der Systemantwort auf die Belastung einstellen. Zur Überwachung des Stromverlaufs kann zwischen der Belastungsvorrichtung 11 und dem elektrischen Energiespeicher 2 ein Stromsensor 13 vorgesehen sein, der den Strom von dem elektrischen Energiespeicher 2 in die Belastungsvorrichtung 11 misst. Ferner kann zur Überwachung des Spannungsverlaufs an den Klemmen des elektrischen Energiespeichers 2 bzw. an den Anschlüssen der Belastungsvorrichtung 11 ein Spannungssensor 12 vorgesehen sein, der den Spannungsverlauf an der entsprechenden Position misst. Als Stromsensor und Spannungssensor kann dabei jeder beliebige Strom- bzw. Spannungssensor vorgesehen sein, der dazu in der Lage ist, den Strom bzw. die Spannung in dem vorgegebenen Wertebereich zu erfassen und hierauf ein korrespondierendes Ausgangssignal bereitzustellen. Insbesondere kann das dabei bereitgestellte Ausgangssignal sowohl ein analoges als auch ein digitales Ausgangssignal umfassen. Die Ausgangssignale des Spannungssensors 12 und/oder des Stromsensors 13 können dabei an der Belastungsvorrichtung 11 bereitgestellt werden, so dass die Belastungsvorrichtung 11 die Belastung des elektrischen Energiespeichers 2 entsprechend den Messergebnissen regeln kann. Ferner können die Ausgangssignale des Spannungssensors 12 und des Stromsensors 13 auch an der Rechenvorrichtung 14 bereitgestellt werden. Die Rechenvorrichtung 14 wertet dabei den Verlauf des elektrischen Stroms, der von dem Stromsensor 13 erfasst worden ist und der elektrischen Spannung, die von dem Spannungssensor 12 erfasst worden ist aus und berechnet dabei einen Phasenunterschied zwischen dem erfassten elektrischen Strom und der erfassten elektrischen Spannung, also einen Phasenunterschied zwischen der elektrischen Belastung durch die Belastungsvorrichtung 11 und sich der hierauf einstellenden Systemantwort. Zusätzlich kann die Rechenvorrichtung 14 optional auch die Amplituden von Strom und Spannung erfassen und auswerten und hieraus die Impedanz des elektrischen Energiespeichers 2 vollständig berechnen. Diese komplexe Impedanz des elektrischen Energiespeichers 2 kann gegebenenfalls für weitere Auswertungen von der Rechenvorrichtung 14 bereitgestellt werden. Für die Bestimmung der Kapazität des elektrischen Energiespeichers 2, wie sie nachfolgend beschrieben wird, ist der Betrag dieser Impedanz jedoch nicht zwingend erforderlich. Vielmehr kann die Bestimmung der Kapazität des elektrischen Energiespeichers 2 ausschließlich basierend auf dem Phasenunterschied zwischen Strom und Spannung, also der Phase der Impedanz des elektrischen Energiespeichers 2, erfolgen. Gegebenenfalls kann jedoch auch der Betrag der ermittelten Impedanz ganz oder teilweise ebenfalls mit zur Bestimmung der Kapazität einbezogen werden. Auch wenn im Folgenden die Bestimmung der Kapazität es elektrischen Energiespeichers 2 nur anhand der ermittelten Phase der Impedanz des elektrischen Energiespeichers 2 beschrieben wird, so soll hierdurch die Berücksichtigung des Betrags der Impedanz nicht ausgeschlossen werden. Insbesondere kann die Bestimmung der Kapazität des elektrischen Energiespeichers auch unter Verwendung der vollständigen ermittelten Impedanz des elektrischen Energiespeichers 2 erfolgen.

Der von der Rechenvorrichtung 14 berechnete Phasenunterschied zwischen Strom und Spannung, also zwischen Belastung und Systemantwort des elektrischen Energiespeichers 2, wird daraufhin der Auswertevorrichtung 15 bereitgestellt. Die Auswerteeinrichtung 15 kann daraufhin basierend auf dem Phasenunterschied zwischen Strom und Spannung an dem elektrischen Energiespeicher 2 die Kapazität des elektrischen Energiespeichers 2 bestimmen. Hierzu vergleicht die Auswertevorrichtung 15 den ermittelten Phasenunterschied zwischen Strom und Spannung mit einem zuvor ermittelten Zusammenhang zwischen Kapazität des elektrischen Energiespeichers 2 und dem hierzu korrespondierenden Phasenunterschied und bestimmt aus dem Vergleich des aktuellen Phasenunterschieds mit dem in der Auswertevorrichtung 15 hinterlegten Zusammenhang einen Wert für die aktuelle Kapazität des elektrischen Energiespeichers 2.

Beispielsweise kann die Auswertevorrichtung 15 einen Speicher umfassen, in dem eine Kennlinie oder ein Kennlinienfeld für die Korrespondenz zwischen Phasenunterschied und Kapazität des elektrischen Energiespeichers 2 abgespeichert ist. Dieser Zusammenhang zwischen Phasenunterschied und Kapazität kann beispielsweise in Form einer ein- oder mehrdimensionalen Funktion abgespeichert sein. Alternativ ist es auch möglich, dass der Zusammenhang zwischen Kapazität und Phasenunterschied sowie gegebenenfalls noch weiteren Parametern in Form von einer oder mehreren Tabellen in dem Speicher der Auswertevorrichtung 15 abgespeichert ist. Insbesondere kann dieser Zusammenhang zwischen Kapazität und Phasenunterschied sowie gegebenenfalls weiteren Parametern zuvor messtechnisch an realen äquivalenten Energiespeichern ermittelt worden sein. Alternativ ist es auch denkbar, den Zusammenhang zwischen Kapazität und Phasenunterschied und gegebenenfalls weiteren Parametern zuvor anhand von Simulationen rechnerisch zu ermitteln. Gegebenenfalls können in dem Speicher der Auswertevorrichtung 15 auch nur wenige Stützstellen als konkrete Werte abgelegt sein. In diesem Fall kann die Auswertevorrichtung 15 zur Bestimmung der Kapazität des elektrischen Energiespeichers 2 eine Interpolation basierend auf diesen Stützstellen durchführen, um die Kapazität des elektrischen Energiespeichers 2 möglichst präzise zu bestimmen. Hierzu kann beispielsweise eine lineare, quadratische oder höher Funktion basierend auf den abgespeicherten Stützstellenwerten bestimmt werden.

Zur Steigerung der Genauigkeit der zu ermittelnden Kapazität des elektrischen Energiespeichers 2 können bei der Bestimmung der Kapazität durch die Auswertevorrichtung 15 auch noch weitere Parameter des elektrischen Energiespeichers 2 berücksichtigt werden. Beispielsweise kann die Temperatur des elektrischen Energiespeichers 2 mit in die Bestimmung der Kapazität einbezogen werden. Hierzu kann die Temperatur des elektrischen Energiespeichers 2 vor der Bestimmung der Kapazität ermittelt werden. Beispielsweise kann die Temperatur des elektrischen Energiespeichers 2 von einem an dem elektrischen Energiespeicher 2 angeordneten Temperatursensor 16 ermittelt werden. Alternativ ist es jedoch auch möglich, die Temperatur des elektrischen Energiespeichers 2 ebenfalls basierend auf der Phase der komplexen Impedanz des elektrischen Energiespeichers 2 zu ermitteln. Hierzu kann der elektrische Energiespeicher 2 mit einem weiteren Belastungssignal belastet werden. Diese Belastung kann analog zu der Belastung für die Bestimmung der Kapazität des elektrischen Energiespeichers 2 beispielsweise ebenfalls durch die Belastungsvorrichtung 11 erfolgen. Die Belastung des elektrischen Energiespeichers 2 zur Bestimmung der Temperatur unterscheidet sich dabei von der Belastung zur Bestimmung der Kapazität darin, dass für die Bestimmung der Temperatur der elektrische Energiespeicher 2 mit einem periodischen Belastungssignal beaufschlagt wird, dessen Frequenz höher ist als die Frequenz des Belastungssignals zur Bestimmung der Kapazität des elektrischen Energiespeichers 2. Die Frequenz des Belastungssignals zur Bestimmung der Temperatur kann dabei beispielsweise im Bereich von mehreren zehn Hertz oder gegebenenfalls im Bereich von mehr als einhundert Hertz liegen. Anschließend kann durch Auswertung des Phasenunterschieds zwischen Belastungssignal und sich darauf einstellender Systemantwort im quasi-stationären Zustand basierend auf einem zuvor ermittelten Zusammenhang zwischen Phasenunterschied und Temperatur die aktuelle Temperatur des elektrischen Energiespeichers 2 bestimmt werden.

Ferner können in die Bestimmungen der Kapazität des elektrischen Energiespeichers 2 auch weitere Parameter, wie beispielsweise der Ladezustand des elektrischen Energiespeichers, der Typ bzw. die Kennzeichnung des elektrischen Energiespeichers oder beliebige weitere Parameter mit einbezogen werden. In diesem Fall können in der Auswertevorrichtung 15 die Abhängigkeit der Kapazität von den zu berücksichtigenden weiteren Parametern ebenfalls in Form einer mehrdimensionalen Funktion oder eines mehrdimensionalen Kennlinienfeldes abgespeichert werden. Basierend auf dem so hinterlegten Zusammenhang zwischen Kapazität und den ermittelten Parametern des elektrischen Energiespeichers kann die aktuelle Kapazität des elektrischen Energiespeichers durch die Auswertevorrichtung 15 ermittelt werden. Insbesondere kann die Auswertevorrichtung 15 hierzu mit einem Batteriemanagementsystem 20 oder gegebenenfalls beliebigen weiteren Komponenten verbunden werden, um von dem Batteriemanagementsystem 20 oder den weiteren Komponenten die erforderlichen Informationen über die weiteren zu berücksichtigenden Parameter zu erhalten.

Ebenso kann die Auswertevorrichtung 15 die ermittelte Kapazität des elektrischen Energiespeichers 2 an das Batteriemanagementsystem 20 oder eine beliebige weitere Komponente weiterleiten. Basierend auf der ermittelten Kapazität des elektrischen Energiespeichers 2 kann daraufhin gegebenenfalls eine Warnung bei Unterschreitung einer vorgegebenen minimalen Kapazität des elektrischen Energiespeichers 2 ausgegeben werden. Alternativ kann der Verlauf der ermittelten Kapazität des elektrischen Energiespeichers 2 auch in einem Speicher des Batteriemanagementsystems 20 oder einem beliebigen weiteren Speicher abgespeichert werden und gegebenenfalls zu einem späteren Zeitpunkt zu Servicezwecken oder ähnlichem ausgelesen werden. Beliebige weitere Auswertungen der ermittelten Kapazität des elektrischen Energiespeichers 2 sind darüber hinaus ebenso möglich.

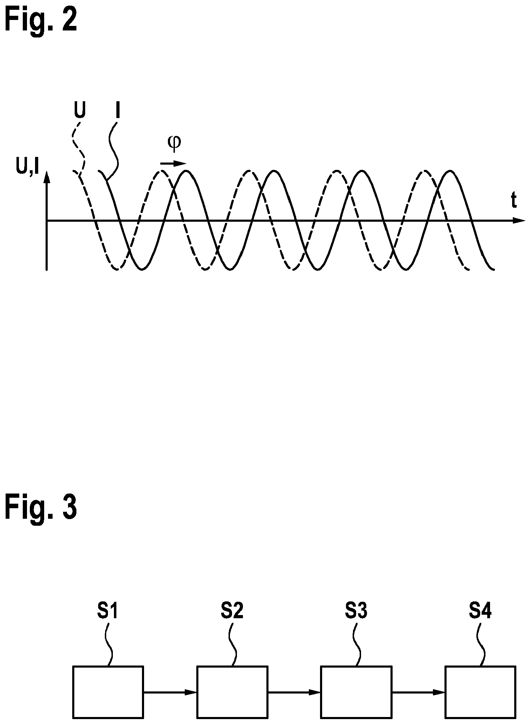

Figur 2 zeigt eine schematische Darstellung des Verlaufs von Strom U und Spannung I, wie sie bei der Bestimmung der Kapazität des elektrischen Energiespeichers 2 durch die Vorrichtung 10 zur Bestimmung der Kapazität auftreten können. Wie hierbei zu erkennen ist, wird sich im quasi-stationären Zustand nach der Belastung des elektrischen Energiespeichers 2 mit einem vorgegebenen Belastungssignal ein Stromverlauf I einstellen, der zu dem Spannungsverlauf U einen konstanten Phasenunterschied ϕ aufweist. Dieser Phasenunterschied ϕ wird durch die Rechenvorrichtung 14 bestimmt und dient anschließend in der Auswertevorrichtung 15 zur Bestimmung der aktuellen Kapazität des elektrischen Energiespeichers 2.

Neben dem hier dargestellten sinusförmigen Verlauf für das periodische Belastungssignal sind darüber hinaus auch beliebige andere periodische Belastungssignale, insbesondere rechteckförmige, trapezförmige, dreieckförmige oder beliebige weitere Belastungssignale denkbar.

Figur 3 zeigt eine schematische Darstellung eines Ablaufdiagramms, wie es einem Verfahren zur Bestimmung einer Kapazität eines elektrischen Energiespeichers 2 gemäß einer Ausführungsform zugrunde liegt. In Schritt S1 wird der elektrische Energiespeicher 2 mit einem periodischen Belastungssignal belastet. Bei dem Belastungssignal kann es sich um die Belastung mit einem vorgegebenen Stromverlauf und alternativ mit einem vorgegebenen Spannungsverlauf handeln. In Schritt S2 wird die Systemantwort des elektrischen Energiespeichers 2 auf die Belastung mit dem periodischen Belastungssignal gemessen und anschließend in Schritt S3 ein Phasenunterschied zwischen dem periodischen Belastungssignal und der gemessenen Systemantwort des elektrischen Energiespeichers 2 ermittelt. Die Ermittlung der Phasenverschiebung zwischen Belastungssignal und Systemantwort erfolgt dabei erst dann, wenn sich auf die periodische Belastung des elektrischen Energiespeichers 2 eine quasi-stationäre Systemantwort eingestellt hat.

In Schritt S4 erfolgt schließlich die Bestimmung der Kapazität des elektrischen Energiespeichers 2. Die Kapazität des elektrischen Energiespeichers 2 wird basierend auf der ermittelten Phasenverschiebung zwischen Belastungssignal und gemessener Systemantwort des elektrischen Energiespeichers bestimmt, wie dies weiter oben bereits ausführlich erläutert worden ist. Insbesondere kann zur Bestimmung der Kapazität des elektrischen Energiespeichers eine Kennlinie bzw. ein Kennlinienfeld für den Zusammenhang zwischen Kapazität und Phasenverschiebung sowie gegebenenfalls weiteren Parametern des elektrischen Energiespeichers 2 verwendet werden.

Gegebenenfalls kann basierend auf der ermittelten Kapazität des elektrischen Energiespeichers 2 der Zustand des elektrischen Energiespeichers 2 klassifiziert werden. Hierzu kann beispielsweise die ermittelte Kapazität des elektrischen Energiespeichers 2 mit einem vorgegebenen Grenzwert verglichen werden. Überschreitet die ermittelte Kapazität den vorgegebenen Grenzwert, so kann der elektrischen Energiespeicher 2 als "gut" oder "intakt" klassifiziert werden. Unterschreitet die ermittelte Kapazität des elektrischen Energiespeichers 2 den vorgegebenen Grenzwert, so kann der elektrischen Energiespeicher 2 als "schlecht" oder "fehlerhaft" klassifiziert werden. Neben einer Klassifikation des elektrischen Energiespeichers 2 in nur zwei Klassen ist ferner auch eine Klassifikation in mehr als zwei Klassen möglich. So können beispielsweise mehrere Grenzwerte vorgegeben werden und hierdurch eine feinere Abstufung der Klassifikation des elektrischen Energiespeichers 2 in mehrere Klassen erfolgen. Beispielsweise kann eine Klassifikation in drei, vier, fünf, acht, zehn, oder eine beliebige andere Anzahl von Klassen erfolgen.

Der vorgegebene Grenzwert bzw. die vorgegebenen Grenzwerte können hierbei beispielsweise fest vorgegeben werden. Insbesondere sind auch typ- bzw. bauartabhängige Grenzwerte für den jeweiligen elektrischen Energiespeicher 2. möglich. Darüber hinaus ist es auch möglich, den Grenzwert bzw. die Grenzwerte für die Klassifikation des elektrischen Energiespeichers 2 anzupassen.

Zusammenfassend betrifft die vorliegende Erfindung die Bestimmung der Kapazität eines elektrischen Energiespeichers wie beispielsweise einer wiederaufladbaren Batterie, insbesondere einer Traktionsbatterie eines Elektrofahrzeugs, basierend auf der Phase der komplexen Impedanz des elektrischen Energiespeichers. Hierzu wird die Impedanz des elektrischen Energiespeichers bestimmt, indem der Energiespeicher mit einer vorgegebenen periodischen Belastung belastet wird und sich die darauf einstellende Systemantwort ermittelt wird. Anhand des Zusammenhangs zwischen Phase der komplexen Impedanz des elektrischen Energiespeichers und der Kapazität des elektrischen Energiespeichers kann daraufhin die Kapazität des elektrischen Energiespeichers auf einfache Weise zuverlässig ermittelt werden.

## Patentansprüche

1. Vorrichtung (1) zur Bestimmung einer Kapazität eines elektrischen Energiespeichers (2), mit:
einer Belastungsvorrichtung (11), die dazu ausgelegt ist, den elektrischen Energiespeicher (2) mit einem periodischen Belastungssignal elektrisch zu belasten;
einer Messevorrichtung (12, 13), die dazu ausgelegt ist, eine Systemantwort des elektrischen Energiespeichers (2) auf die Belastung mit dem periodischen Belastungssignal zu messen;
einer Rechenvorrichtung (14), die dazu ausgelegt ist, eine Phasenverschiebung zwischen dem periodischen Belastungssignal und der gemessenen Systemantwort des elektrischen Energiespeichers (2) zu ermitteln; und
einer Auswertevorrichtung (15), die dazu ausgelegt ist, die Kapazität des elektrischen Energiespeichers (2) unter Verwendung der ermittelten Phasenverschiebung zwischen periodischem Belastungssignal und der gemessenen Systemantwort des elektrischen Energiespeichers (2) zu bestimmen,
**dadurch gekennzeichnet, dass** die Auswertevorrichtung (15) ferner dazu ausgelegt ist, die Kapazität des elektrischen Energiespeichers (2) unter Verwendung einer Temperatur des elektrischen Energiespeichers (2) zu bestimmen, wobei eine Detektorvorrichtung (16) die Temperatur des elektrischen Energiespeichers (2) basierend auf einer Belastung des elektrischen Energiespeichers (2) mit einem weiteren periodischen Belastungssignal und der Auswertung einer Systemantwort des elektrischen Energiespeichers (2) auf die Belastung des elektrischen Energiespeichers (2) mit dem weiteren Belastungssignal bestimmt, wobei die Frequenz des weiteren periodischen Belastungssignals größer ist als die Frequenz des periodischen Belastungssignals mit dem der elektrische Energiespeicher zur Bestimmung der Kapazität belastet wird.

2. Vorrichtung (1) nach Anspruch 1, wobei die Auswertevorrichtung (15) einen Speicher umfasst, der dazu ausgelegt ist, einen zuvor ermittelten Zusammenhang zwischen Phasenverschiebung und Kapazität des elektrischen Energiespeichers (2) zu speichern, und
wobei die Auswertevorrichtung (15) die Kapazität des elektrischen Energiespeichers (2) basierend auf dem in dem Speicher abgespeicherten Zusammenhang zwischen Phasenverschiebung und Kapazität bestimmt.

3. Vorrichtung (1) nach Anspruch 1 oder 2, wobei die Belastungsvorrichtung (11) dazu ausgelegt ist, den elektrischen Energiespeicher (2) mit einem periodischen Belastungssignal zu belasten, das eine Frequenz zwischen einem und zehn Hertz aufweist.

4. Vorrichtung (1) nach einem der Ansprüche 1 bis 3, wobei die Frequenz des periodischen Belastungssignals anpassbar ist.

5. Vorrichtung (1) nach einem der Ansprüche 1 bis 4, wobei die Auswertevorrichtung (15) ferner dazu ausgelegt ist, die Kapazität des elektrischen Energiespeichers (2) unter Verwendung, eines Ladezustanded des elektrischen Energiespeichers (2), einer Kennung des elektrischen Energiespeichers (2) und/oder mindestens einem weiteren Parameter des elektrischen Energiespeichers (2) zu bestimmen.

6. Vorrichtung (1) nach einem der Ansprüche 1 bis 5, wobei die Belastungsvorrichtung (11) den elektrischen Energiespeicher (2) mit einem vorbestimmten Stromsignal belastet, und die Messvorrichtung als Systemantwort einen resultierenden Spannungsverlauf misst.

7. Verfahren zur Bestimmung einer Kapazität eines elektrischen Energiespeichers (2), mit den Schritten:
Belasten (S1) des elektrischen Energiespeichers (2) mit einem periodischen Belastungssignal;
Messen (S2) eine Systemantwort des elektrischen Energiespeichers (2) auf die Belastung mit dem periodischen Belastungssignal;
Ermitteln (S3) eine Phasenverschiebung zwischen dem periodischen Belastungssignal und der gemessenen Systemantwort des elektrischen Energiespeichers (2); und
Bestimmen (S4) der Kapazität des elektrischen Energiespeichers (2) unter Verwendung der ermittelten Phasenverschiebung zwischen dem periodischem Belastungssignal und der gemessenen Systemantwort des elektrischen Energiespeichers (2),
**dadurch gekennzeichnet, dass** die Kapazität des elektrischen Energiespeichers (2) unter Verwendung einer Temperatur des elektrischen Energiespeichers (2) bestimmen wird, wobei die Temperatur des elektrischen Energiespeichers (2) basierend auf einer Belastung des elektrischen Energiespeichers (2) mit einem weiteren periodischen Belastungssignal und der Auswertung einer Systemantwort des elektrischen Energiespeichers (2) auf die Belastung des elektrischen Energiespeichers (2) mit dem weiteren Belastungssignal bestimmt wird, wobei die Frequenz des weiteren periodischen Belastungssignals größer ist als die Frequenz des periodischen Belastungssignals mit dem der elektrische Energiespeicher zur Bestimmung der Kapazität belastet wird.

8. Verfahren nach Anspruch 7, wobei der Schritt (S4) zum Bestimmen der Kapazität des elektrischen Energiespeichers (2) die Kapazität des elektrischen Energiespeichers (2) unter Verwendung einer Kennlinie von zuvor ermittelten Zusammenhängen zwischen Phasenverschiebung und Kapazität bestimmt.

9. Verfahren nach Anspruch 7 oder 8, mit einem Schritt zum Klassifizieren des elektrischen Energiespeichers (2) basierend auf der bestimmten Kapazität.

## Claims

1. Device (1) for determining a capacity of an electrical energy store (2), having:
a loading device (11) that is designed to electrically load the electrical energy store (2) with a periodic load signal;
a measuring device (12, 13) that is designed to measure a system response of the electrical energy store (2) to the loading with the periodic load signal;
a computing device (14) that is designed to ascertain a phase shift between the periodic load signal and the measured system response of the electrical energy store (2); and
an evaluation device (15) that is designed to determine the capacity of the electrical energy store (2) using the ascertained phase shift between the periodic load signal and the measured system response of the electrical energy store (2),
**characterized in that** the evaluation device (15) is also designed to determine the capacity of the electrical energy store (2) using a temperature of the electrical energy store (2), wherein a detector device (16) determines the temperature of the electrical energy store (2) on the basis of a loading of the electrical energy store (2) with a further periodic load signal and the evaluation of a system response of the electrical energy store (2) to the loading of the electrical energy store (2) with the further load signal, the frequency of the further periodic load signal being greater than the frequency of the periodic load signal that is used to load the electrical energy store in order to determine the capacity.

2. Device (1) according to Claim 1, wherein the evaluation device (15) comprises a memory that is designed to store a previously ascertained relationship between the phase shift and the capacity of the electrical energy store (2), and
wherein the evaluation device (15) determines the capacity of the electrical energy store (2) on the basis of the relationship between the phase shift and the capacity that is stored in the memory.

3. Device (1) according to Claim 1 or 2, wherein the loading device (11) is designed to load the electrical energy store (2) with a periodic load signal that has a frequency of between one and ten hertz.

4. Device (1) according to one of Claims 1 to 3, wherein the frequency of the periodic load signal is adjustable.

5. Device (1) according to one of Claims 1 to 4, wherein the evaluation device (15) is also designed to determine the capacity of the electrical energy store (2) using a state of charge of the electrical energy store (2), an identifier of the electrical energy store (2) and/or at least one further parameter of the electrical energy store (2).

6. Device (1) according to one of Claims 1 to 5, wherein the loading device (11) loads the electrical energy store (2) with a predetermined current signal, and the measuring device measures a resulting voltage characteristic as the system response.

7. Method for determining a capacity of an electrical energy store (2), having the steps of:
loading (S1) the electrical energy store (2) with a periodic load signal;
measuring (S2) a system response of the electrical energy store (2) to the loading with the periodic load signal;
ascertaining (S3) a phase shift between the periodic load signal and the measured system response of the electrical energy store (2); and
determining (S4) the capacity of the electrical energy store (2) using the ascertained phase shift between the periodic load signal and the measured system response of the electrical energy store (2),
**characterized in that** the capacity of the electrical energy store (2) is determined using a temperature of the electrical energy store (2), wherein the temperature of the electrical energy store (2) is determined on the basis of a loading of the electrical energy store (2) with a further periodic load signal and the evaluation of a system response of the electrical energy store (2) to the loading of the electrical energy store (2) with the further load signal, the frequency of the further periodic load signal being greater than the frequency of the periodic load signal that is used to load the electrical energy store in order to determine the capacity.

8. Method according to Claim 7, wherein the step (S4) for determining the capacity of the electrical energy store (2) determines the capacity of the electrical energy store (2) using a characteristic curve of previously ascertained relationships between the phase shift and the capacity.

9. Method according to Claim 7 or 8, having a step for classifying the electrical energy store (2) on the basis of the capacity determined.

## Revendications

1. Dispositif (1) permettant de déterminer une capacité d'un accumulateur d'énergie électrique (2), comprenant :
un dispositif d'application de charge (11) qui est conçu pour appliquer une charge électrique à l'accumulateur d'énergie électrique (2) avec un signal d'application de charge périodique ;
un dispositif de mesure (12, 13) qui est conçu pour mesurer une réponse du système de l'accumulateur d'énergie électrique (2) à l'application de charge avec le signal d'application de charge périodique ;
un dispositif de calcul (14) qui est conçu pour établir un déphasage entre le signal d'application de charge périodique et la réponse du système mesurée de l'accumulateur d'énergie électrique (2) ; et
un dispositif d'évaluation (15) qui est conçu pour déterminer la capacité de l'accumulateur d'énergie électrique (2) en utilisant le déphasage établi entre le signal d'application de charge périodique et la réponse du système mesurée de l'accumulateur d'énergie électrique (2),
**caractérisé en ce que** le dispositif d'évaluation (15) est en outre conçu pour déterminer la capacité de l'accumulateur d'énergie électrique (2) en utilisant une température de l'accumulateur d'énergie électrique (2), un dispositif de détection (16) déterminant la température de l'accumulateur d'énergie électrique (2) sur la base d'une application de charge à l'accumulateur d'énergie électrique (2) avec un autre signal d'application de charge périodique et de l'évaluation d'une réponse du système de l'accumulateur d'énergie électrique (2) à l'application de charge à l'accumulateur d'énergie électrique (2) avec l'autre signal d'application de charge, la fréquence de l'autre signal d'application de charge périodique étant supérieure à la fréquence du signal d'application de charge périodique qui est appliqué à l'accumulateur d'énergie électrique pour la détermination de la capacité.

2. Dispositif (1) selon la revendication 1, dans lequel le dispositif d'évaluation (15) comprend une mémoire qui est conçue pour stocker une relation établie précédemment entre le déphasage et la capacité de l'accumulateur d'énergie électrique (2), et
le dispositif d'évaluation (15) déterminant la capacité de l'accumulateur d'énergie électrique (2) sur la base de la relation entre le déphasage et la capacité, stockée dans la mémoire.

3. Dispositif (1) selon la revendication 1 ou 2, dans lequel le dispositif d'application de charge (11) est conçu pour appliquer une charge à l'accumulateur d'énergie électrique (2) avec un signal d'application de charge périodique qui présente une fréquence entre un et dix Hertz.

4. Dispositif (1) selon l'une quelconque des revendications 1 à 3, dans lequel la fréquence du signal d'application de charge périodique peut être adaptée.

5. Dispositif (1) selon l'une quelconque des revendications 1 à 4, dans lequel le dispositif d'évaluation (15) est en outre conçu pour déterminer la capacité de l'accumulateur d'énergie électrique (2) en utilisant un état de charge de l'accumulateur d'énergie électrique (2), un identifiant de l'accumulateur d'énergie électrique (2) et/ou au moins un autre paramètre de l'accumulateur d'énergie électrique (2).

6. Dispositif (1) selon l'une quelconque des revendications 1 à 5, dans lequel le dispositif d'application de charge (11) applique une charge à l'accumulateur d'énergie électrique (2) avec un signal de courant prédéterminé, et le dispositif de mesure mesure un tracé de tension résultant en tant que réponse du système.

7. Procédé permettant de déterminer une capacité d'un accumulateur d'énergie électrique (2), comprenant les étapes consistant à :
appliquer une charge (S1) à l'accumulateur d'énergie électrique (2) avec un signal d'application de charge périodique ;
mesurer (S2) une réponse du système de l'accumulateur d'énergie électrique (2) à l'application de charge avec le signal d'application de charge périodique ;
établir (S3) un déphasage entre le signal d'application de charge périodique et la réponse du système mesurée de l'accumulateur d'énergie électrique (2) ; et
déterminer (S4) la capacité de l'accumulateur d'énergie électrique (2) en utilisant le déphasage établi entre le signal d'application de charge périodique et la réponse du système mesurée de l'accumulateur d'énergie électrique (2),
**caractérisé en ce que** la capacité de l'accumulateur d'énergie électrique (2) est déterminée en utilisant une température de l'accumulateur d'énergie électrique (2), la température de l'accumulateur d'énergie électrique (2) étant déterminée sur la base d'une application de charge à l'accumulateur d'énergie électrique (2) avec un autre signal d'application de charge périodique et de l'évaluation d'une réponse du système de l'accumulateur d'énergie électrique (2) à l'application de charge à l'accumulateur d'énergie électrique (2) avec l'autre signal d'application de charge, la fréquence de l'autre signal d'application de charge périodique étant supérieure à la fréquence du signal d'application de charge périodique qui est appliqué à l'accumulateur d'énergie électrique pour déterminer la capacité.

8. Procédé selon la revendication 7, dans lequel l'étape (S4) de détermination de la capacité de l'accumulateur d'énergie électrique (2) détermine la capacité de l'accumulateur d'énergie électrique (2) en utilisant une courbe caractéristique de relations entre le déphasage et la capacité, établies précédemment.

9. Procédé selon la revendication 7 ou 8, comprenant une étape consistant à classifier l'accumulateur d'énergie électrique (2) sur la base de la capacité déterminée.
